# EUROPÄISCHE PATENTSCHRIFT

(11) **EP 2 609 653 B1**
(45) Veröffentlichungstag und Bekanntmachung des Hinweises auf die Patenterteilung: **26.12.2018**
(21) Anmeldenummer: 11755036.8
(22) Anmeldetag: 23.08.2011
(51) Int. Cl.: H01R 4/02, H01R 12/57, H05K 3/32

(54) **Vorrichtung umfassend ein Gehäuse mit einem Schaltungsträger**
Device comprising a housing with a circuit carrier
Dispositif comprenant un couvercle avec un support de circuit

(30) Priorität: 25.08.2010 DE 102010039740
(43) Veröffentlichungstag der Anmeldung: 03.07.2013
(73) Patentinhaber: Robert Bosch GmbH, 70442 Stuttgart (DE)
(72) Erfinder: ILIC, Erich, 72805 Lichtenstein (DE); KAECHELE, Uwe, 72813 St. Johann-Wuertingen (DE)
(86) Internationale Anmeldenummer: PCT/EP2011/064467
(87) Internationale Veröffentlichungsnummer: WO 2012/025524

(56) Entgegenhaltungen:
- EP-A1- 0 559 057
- WO-A1-2009/082734
- DE-A1- 10 215 078
- DE-A1-102005 050 796
- DE-U1- 29 818 135
- US-A- 4 422 128
- US-A- 5 709 574
- US-A- 5 938 456

## Beschreibung

Die Erfindung betrifft eine Vorrichtung, bestehend aus Schaltungsträger mit einem Kontaktelement.

### Stand der Technik

Bei Vorrichtungen der eingangs genannten Art ist es bekannt, den elektrischen Kontakt zu einem Schaltungsträger über Kontaktelemente herzustellen, die im Wesentlichen aus Metallstiften oder Leitungen bestehen. Die Leitungen werden zunächst mit einem Kunststoff umspritzt. Das so entstehende Kontaktelement wird bei der Herstellung des Gehäuses oder eines entsprechenden Gehäuseteil in das Spritzgusswerkzeug eingelegt und mit umspritzt. Das fertige Gehäuseteil enthält demnach nach Beendigung des Fertigungsprozesses bereits das Kontaktelement als integralen Bestandteil. Das Kontaktelement entspricht in seiner Länge dem Abstand zwischen dem Gehäuse und dem Verbraucher, so dass das Kontaktelement unter Umständen weit über das Gehäuse hinausragt. Dadurch werden die Handhabung des Gehäuses im Verlauf der weiteren Montage, sowie der Transport und die Lagerung der Gehäuse erschwert.

Aus der DE 197 27 477 A1 ist ein derartiges Kontaktelement bekannt. Es weist einen angeformten Körper aus einem dielektrischen Material auf, der die Kontaktleitungen im Wesentlichen auf ihrer gesamten Länge umgibt. Die Enden der Kontaktleitungen auf beiden Seiten des Kontaktelements liegen frei und können jeweils über entsprechende Gegenstecker oder Kontaktbuchsen mit der Steuerungsschaltung bzw. dem Verbraucher kontaktiert werden.

Aus der EP 1 955 927 A1 ist eine alternative Kontaktierung zwischen einem Elektromotor und einem Steuergerät für motorisch unterstützte Lenksysteme in Fahrzeugen bekannt. Das Steuergerät weist als Schaltungsträger ein Stanzgitter auf, aus dem unmittelbar Kontaktelemente ausgeformt sind. Kontaktleitungen vom Elektromotor werden durch eine Abdeckung des Steuergeräts zu den Kontaktelementen geführt und von den in den Kontaktelementen ausgebildeten Federklemmen kontaktiert. Diese Ausführung ist jedoch auf Stanzgitter als Schaltungsträger begrenzt.

Die DE 10 2005 050 796 A1 zeigt einen Flachstecker, der geeignet ist, per SMD-Lötverfahren auf der Oberfläche einer Leiterplatte befestigt zu werden. Der Flachstecker weist seitlich wegragende Anschlüsse auf, die derart ausgebildet sind, dass sie nach der Montage des Steckers auf der Leiterplattenoberfläche aufliegen. Die Masseverteilung des Steckers ist so gewählt, dass der Stecker bei der Montage nicht verkippt.

Die WO 2009/082734 A1 zeigt eine Anschlussklemme mit einem Fortsatz, mit dem sie auf der Oberfläche eines Schaltungsträgers verlötet werden kann. Der elektrische Kontakt zu einer Leitung wird durch Klemmen hergestellt, da die Verbindung lösbar sein soll.

Die DE 298 18 135 U1 zeigt ein hülsenförmiges Kontaktelement, das in eine Bohrung einer Leiterplatte eingepresst werden kann. Auch hier ist vorgesehen, die elektrische Verbindung zwischen dem Kontaktelement und einem Stecker klemmend, also lösbar, vorzusehen.

Die EP 0 559 057 A1 zeigt ein im Wesentlichen U-förmiges Kontaktelement mit Aufnahmemitteln für Kontaktleitungen, das auf einem Schaltungsträger aufgelötet werden kann. Die Kontaktleitungen dienen zur Verbindung zweier Leiterplatten. Die Kontaktleitungen werden durch Federkräfte gehalten und kontaktiert.

Die US 5 938 456 A zeigt Kontaktelemente, die auf einen Schaltungsträger aufgelötet werden und die Aufnahmemittel für Steckerkontakte aufweisen, die von oben und von unten in das Kontaktelement eingepresst werden können.

Die US 4,422,128 beschreibt einen Federbügel, in welchen ein Kontaktstift geklemmt werden kann.

Aus der DE 102 15 078 A1 ist eine Leitungshalterung vorbekannt, bei welcher eine Leitung in eine Metallhülse eingeführt und über eine Quetschverbindung oder eine Schweißverbindung kontaktiert wird.

### Offenbarung der Erfindung

Anspruch 1 offenbart eine Vorrichtung nach der Erfindung. Weitere Ausführungsformen sind in den abhängigen Ansprüchen beschrieben. Es wird ein Kontaktelement vorgeschlagen, das geeignet ist, einen elektrischen Kontakt zwischen einem, beispielsweise in einem Gehäuse angeordneten, Schaltungsträger und einer Kontaktleitung herzustellen. Die Kontaktleitung verbindet die Schaltung auf dem Schaltungsträger beispielsweise mit einem externen Verbraucher, einer externen Energiequelle oder einem innerhalb oder außerhalb des Gehäuses angeordneten weiteren elektrischen oder elektronischen Bauteil. Dazu ist das Kontaktelement geeignet ausgebildet, um direkt auf dem Schaltungsträger angeordnet und mit dem Schaltungsträger kontaktiert zu werden. Das Kontaktelement weist weiterhin mindestens ein Aufnahmemittel auf, das geeignet ist eine Kontaktleitung aufzunehmen und dadurch den elektrischen Kontakt zu dem Schaltungsträger herzustellen.

Der Vorteil der Erfindung gegenüber dem Stand der Technik besteht darin, eine Vorrichtung mit einem Kontaktelement vorzusehen, das als separates Bauteil ausgeführt ist und direkt mit dem Schaltungsträger verbunden werden kann. Das erfindungsgemäße Kontaktelement ist einfach aufgebaut, günstig und zeitsparend in der Herstellung. Es ist beispielsweise als Stanzbiegeteil aus Blech ausgebildet und besteht aus einem Material mit einer hohen elektrischen Leitfähigkeit.

Zudem kann die Ausgestaltung des Kontaktelements, insbesondere die Geometrie des Aufnahmemittels, der Form der Kontaktleitungen angepasst werden, so dass beispielsweise Kontaktleitungen mit im Wesentlichen rundem Querschnitt vorgesehen sein können, die besonders einfach in der Herstellung sind.

In einer bevorzugten Ausführung der Erfindung weist das Kontaktelement mehrere Abschnitte auf, von denen ein Abschnitt zur elektrischen Kontaktierung mit dem Schaltungsträger dient. Ein zweiter Abschnitt des Kontaktelementes weist das mindestens eine Aufnahmemittel auf, das geeignet ist, eine elektrische Leitung von dem Verbraucher aufzunehmen, um einen elektrischen Kontakt herzustellen. Die beiden Abschnitte können auf einer oder auf verschiedenen Ebenen ausgebildet sein. Das Aufnahmemittel ist bevorzugt durch eine Ausnehmung gebildet, in der das Ende einer Kontaktleitung angeordnet werden kann.

In einer alternativen Ausführung kann das Kontaktelement einen ersten, hülsenfömigen Abschnitt aufweisen, der als Aufnahmemittel dient. Mit dem ersten Abschnitt ist bevorzugt ein zweiter, kragenartiger Abschnitt verbunden, der an dem Schaltungsträger anliegt und zur elektrischen Kontaktierung mit dem Schaltungsträger dient.

Das erfindungsgemäße Kontaktelement weist vorzugsweise ein oder mehrere Positionierungselemente auf, die zum einen die Position des Kontaktelements auf dem Schaltungsträger festlegen und weiterhin für eine Befestigung des Kontaktelementes sorgen. Diese sind beispielsweise als in Richtung zum Schaltungsträger weisende Stifte oder Laschen ausgebildet, die geeignet sind, in entsprechende Positionierungsöffnungen des Schaltungsträgers einzugreifen. Umgekehrt kann auch der Schaltungsträger Positionierungselemente aufweisen, die in entsprechende Positionierungsöffnungen des Kontaktelements eingreifen.

Nach der Erfindung ist das Kontaktelement geeignet ausgebildet, um mit dem Ende der Kontaktleitung im Bereich des Aufnahmemittels verschweißt zu werden. Dadurch wird der elektrische Kontakt zwischen der Kontaktleitung und dem Kontaktelement hergestellt.

Weiterhin betrifft die Erfindung eine Vorrichtung, bestehend aus einem Gehäuse, insbesondere für ein elektrisches und/oder elektronisches Steuergerät, und einem darin angeordneten Schaltungsträger, wobei der elektrische Kontakt zwischen dem Schaltungsträger und einer oder mehrerer Kontaktleitungen über ein oder mehrere Kontaktelemente nach einer der oben beschriebenen Ausführungen hergestellt wird.

Das Gehäuse weist mindestens eine Durchführungsöffnung auf, durch die eine oder mehrere Kontaktleitungen von einem externen Gerät oder Bauteil ins Innere des Gehäuses geführt sind. Die Enden der Kontaktleitungen werden jeweils von einem Aufnahmemittel eines auf dem Schaltungsträger angeordneten und mit dem Schaltungsträger kontaktierten Kontaktelements aufgenommen. Das Kontaktelement wird bevorzugt auf den Schaltungsträger aufgelötet. Alternativ sind auch andere Kontaktierungsmöglichkeiten denkbar, wie beispielsweise die Verwendung eines elektrisch leitfähigen Klebstoffs.

Bevorzugt ist das Gehäuse mehrteilig aufgebaut und weist ein Bodenteil und ein Deckelteil auf, wobei mindestens eine Durchführungsöffnung im Deckelteil oder im Bodenteil angeordnet ist. Das Bodenteil ist wannenförmig aufgebaut und nimmt den Schaltungsträger auf. Das Deckelteil ist auf das Bodenteil aufsetzbar und verschließt damit das Gehäuse.

Die Durchführungsöffnung des Gehäuses ist trichterförmig ausgebildet und läuft zum Inneren des Gehäuses hin konisch zu. Durch diese Ausgestaltung erfüllt die Durchführungsöffnung die Funktion einer Fügehilfe, durch die die Kontaktleitung bereits während der Montage relativ zu dem Kontaktelement vorzentriert wird.

Die Vorrichtung weist der Schaltungsträger eine Öffnung auf, durch die die Kontaktleitung geführt ist. Die Öffnung des Schaltungsträgers ist im Bereich der Durchführungsöffnung des Gehäuses angeordnet, so dass die Kontaktleitung vom Verbraucher möglichst direkt durch beide Öffnungen geführt werden kann. Die Öffnung kann beispielsweise rund oder schlitzförmig ausgebildet sein. Die Öffnung kann zur Durchführung einer oder mehrerer Kontaktleitungen dienen. Ebenso ist es möglich mehrere Öffnungen im Schaltungsträger vorzusehen. Statt oder zusätzlich zu einer Öffnung kann auch eine am Rand des Schaltungsträgers angeordnete Ausnehmung zur Durchführung einer oder mehrerer Kontaktleitungen vorgesehen sein.

Das Kontaktelement ist im Bereich der Öffnung des Schaltungsträgers auf dem Schaltungsträger angeordnet und kontaktiert. Besonders bevorzugt ist eine Anordnung des Kontaktelements auf der Seite des Schaltungsträgers, die der Durchführungsöffnung durch das Gehäuse abgewandt ist.

Alternativ oder zusätzlich kann das Kontaktelement teilweise in der Öffnung des Schaltungsträgers angeordnet sein.

In einer besonders bevorzugten Ausgestaltung überragt ein Abschnitt des Kontaktelements, an dem das Aufnahmemittel ausgebildet ist, die Öffnung des Schaltungsträgers. Damit liegen das Aufnahmemittel des Kontaktelements, die Öffnung des Schaltungsträgers und die Durchführungsöffnung des Gehäuses auf einer gemeinsamen Linie. Der Vorteil einer derartigen Anordnung besteht darin, dass eine als geradliniger Kontaktstift ausgeführte Kontaktleitung einfach eingeführt und kontaktiert werden kann, wodurch der Herstellungsaufwand der Vorrichtung vereinfacht ist.

Der Vorteil einer solchen Vorrichtung besteht darin, dass sie einfach in der Montage ist, da keine aufwändigen zusätzlichen Teile, wie Kontaktbuchsen an dem Gehäuse, zur Kontaktierung benötigt werden. Beispielsweise kann eine derartige Vorrichtung Teil eines Antiblockierbremssystems eines Kraftfahrzeugs sein. In diesem Beispiel wird der Schaltungsträger in dem Gehäuse mit dem Elektromotor zum Antrieb eines Pumpenaggregats kontaktiert.

### Kurze Beschreibung der Zeichnungen

Figur 1a zeigt einen Schnitt durch ein Kontaktelement nach einer Ausführung der Erfindung.
Figur 1b stellt schematisch in Draufsicht das Kontaktelement aus Figur 1a dar.
Figur 2 zeigt einen Schnitt durch ein Kontaktelement nach einer zweiten Ausführung der Erfindung.
Figur 3a zeigt in isometrischer Ansicht zwei Kontaktelemente auf einem Schaltungsträger.
Figur 3b zeigt einen Ausschnitt aus einer erfindungsgemäßen Vorrichtung.

### Ausführungsformen der Erfindung

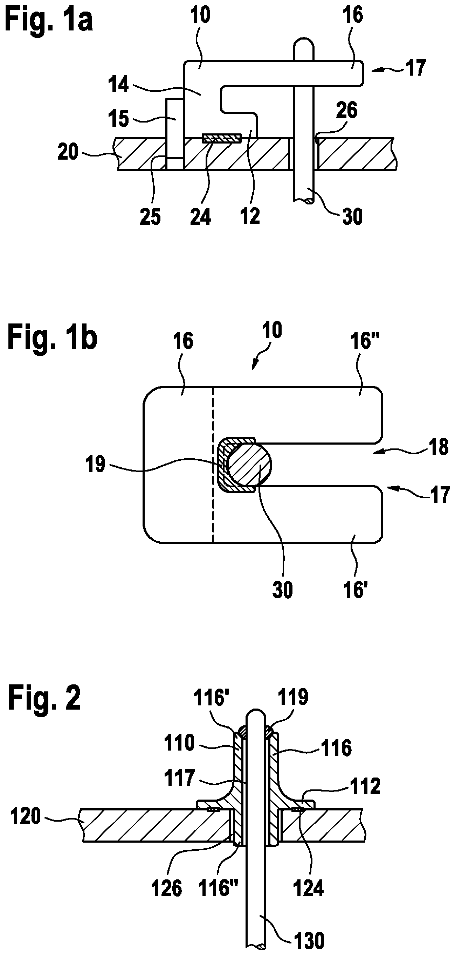

In Figur 1a ist schematisch ein erfindungsgemäßes Kontaktelement 10 im Querschnitt dargestellt. Außerdem ist ausschnittsweise der Schaltungsträger dargestellt, auf dem das Kontaktelement 10 angeordnet ist und der in diesem Beispiel als Leiterplatte 20 ausgeführt ist. Alternativ kann der Schaltungsträger beispielsweise auch als Stanzgitter ausgebildet sein. Das Kontaktelement 10 weist einen ersten Abschnitt 12 auf, der parallel zur Leiterplatte 20 verläuft und auf der Leiterplatte 20 aufliegt. Das Kontaktelement 10 weist einen zweiten Abschnitt 16 auf, der parallel zur Leiterplatte 20 verläuft. Die Abschnitte 12 und 16 sind durch einen Zwischenabschnitt 14 miteinander verbunden, der im Wesentlichen senkrecht zur Leiterplatte 20 und senkrecht zu den Abschnitten 12 und 16 verläuft. Alternativ kann der Zwischenabschnitt 14 beispielsweise auch U-förmig ausgebildet sein. Der Abschnitt 12 liegt auf der Leiterplatte 20 auf und ist über eine Lötstelle 24 mit der Leiterplatte 20 elektrisch kontaktiert. Die Leiterplatte 20 weist eine Öffnung 26 auf, durch die eine Kontaktleitung 30 hindurchgeführt ist. Der Abschnitt 16 überragt die Öffnung 26 auf einer Seite der Leiterplatte 20.

Figur 1b zeigt in einer schematischen Darstellung das Kontaktelement 10 aus Figur 1a in Draufsicht. Wie in dieser Ansicht zu erkennen ist, ist der Abschnitt 16 des Kontaktelements gabelförmig ausgeführt. Er weist zwei Gabelzinken 16' und 16" auf, die eine Ausnehmung 18 zwischen sich ausbilden. Die Ausnehmung 18 und die Gabelzinken 16' und 16" bilden zusammen das Aufnahmemittel 17 des Kontaktelements 10. Die Anordnung der Gabelzinken kann, wie in diesem Beispiel etwa U-förmig ausgeführt sein, es ist aber auch beispielsweise eine V-förmige Ausgestaltung denkbar. In der Ausnehmung 18 ist die Kontaktleitung 30 aufgenommen. Die Kontaktleitung 30 weist in diesem Beispiel einen kreisförmigen Querschnitt auf. Ebenso sind auch anders geformte Kontaktleitungen denkbar, beispielsweise mit ovalem oder rechteckigem Querschnitt. Im Endbereich der Ausnehmung 18, in dem die Kontaktleitung 30 an dem Kontaktelement 10 anliegt, ist die Kontaktleitung 30 mit dem Kontaktelement 10 verschweißt. Die Schweißstelle 19 bildet den elektrischen Kontakt zwischen der Kontaktleitung 30 und dem Kontaktelement 10. Die Schweißstelle 19 kann punktuell ausgebildet sein oder kann, wie in Figur 1b dargestellt entlang eines Teils des Umfangs der Kontaktleitung verlaufen. Das Kontaktelement 10 besteht dazu aus einem schweißbaren Material, z.B. aus Stahl. Es kann jedoch beispielsweise auch aus Kupfer oder Aluminium bestehen. Bevorzugt werden das Kontaktelement 10 und die Kontaktleitung 30 durch Widerstandsschweißen verbunden, es können aber auch alternative Schweißverfahren, wie beispielsweise Laserschweißen, eingesetzt werden.

In Figur 1a ist weiterhin zu erkennen, dass das Kontaktelement 10 ein an dem Verbindungsabschnitt 14 ausgebildetes Positionierungselement 15 aufweist. Das Positionierungselement 15 ist zapfenartig geformt und greift in eine korrespondierende Positionierungsöffnung 25 der Leiterplatte 20 ein. Dadurch wird das Kontaktelement 10 zusätzlich fixiert. Das Positionierungselement 15 kann entweder einteilig mit dem Kontaktelement 10 ausgeführt sein, oder als separates Teil vor oder nach dem Aufsetzen des Kontaktelements in die Positionierungsöffnung 25 eingebracht werden.

Figur 2 stellt eine alternative Ausführung eines erfindungsgemäßen Kontaktelements 110 dar. Das Kontaktelement 110 weist einen hülsenförmigen Abschnitt 116 auf. An dem hülsenförmigen Abschnitt ist ein kragenartiger Abschnitt 112 angeordnet. Der Abschnitt 112 umgibt den hülsenförmigen Abschnitt ringförmig. Der hülsenförmige Abschnitt 116 ist im Wesentlichen als Hohlzylinder ausgebildet. Das Innere des hülsenförmigen Abschnitts 116 bildet das Aufnahmemittel 117 für eine Kontaktleitung 130, deren Ende in den Abschnitt 116 eingeführt wird. In diesem Beispiel ragt das Ende der Kontaktleitung 130 über den Abschnitt 116 hinaus, es ist jedoch genauso denkbar, dass die Kontaktleitung 130 bündig mit dem Abschnitt 116 abschließt oder innerhalb des Aufnahmemittels endet. Eine Schweißnaht 119, die beispielsweise durch einen Laserschweißprozess erzeugt werden kann, bildet den elektrische Kontakt zwischen dem Kontaktelement 110 und der Kontaktleitung 130. Alternativ kann zur elektrischen Kontaktierung zwischen der Kontaktleitung 130 und dem Kontaktelement 110 auch Lot oder ein elektrisch leitfähiger Klebstoff verwendet werden. Die Schweißnaht 119 ist in dem dargestellten Beispiel in dem Bereich der oberen Öffnung 116' des Abschnitts 116 angeordnet, in dem das Ende der Kontaktleitung 130 über den Abschnitt 116 hinausragt. Alternativ oder zusätzlich kann die Schweißnaht auch in einem anderen Bereich, beispielsweise dem Bereich der unteren Öffnung 116" des Abschnitts 116 angeordnet sein.

Der kragenförmige Abschnitt 112 liegt auf der Oberfläche einer Leiterplatte 120 auf und ist an mindestens einer Lötstelle 124 mit der Leiterplatte kontaktiert. Die Lötstelle kann beispielsweise punktförmig oder umlaufend ausgebildet sein. Alternativ kann der kragenförmige Abschnitt 112 auch auf der Unterseite der Leiterplatte 120 aufliegen und dort durch Löten oder Kleben elektrisch kontaktiert sein.

Der unterhalb des kragenförmigen Abschnitts 112 angeordnete Teil des Abschnitts 116 greift in eine Öffnung 126 der Leiterplatte 120 ein. Dadurch wird das Kontaktelement 110 auf der Leiterplatte 120 positioniert und befestigt, ohne dass zusätzliche Positionierungselemente nötig sind.

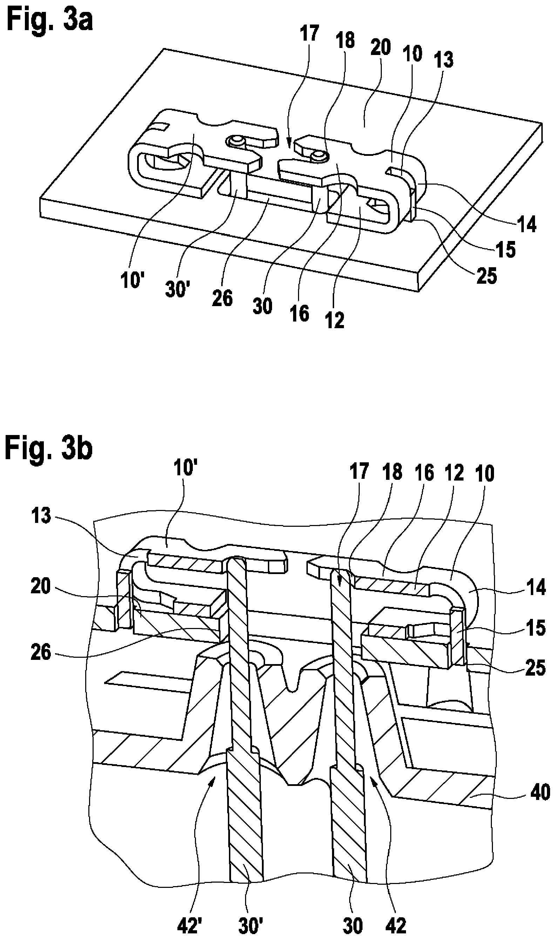

In den meisten Fällen wird mehr als eine Kontaktleitung vom Verbraucher zum Schaltungsträger benötigt. In diesen Fällen können entsprechend mehrere Kontaktelemente auf dem Schaltungsträger vorgesehen sein. Figur 3a zeigt beispielhaft zwei Kontaktelemente 10 und 10', die auf einer Leiterplatte 20 angeordnet und kontaktiert sind. Die beiden Kontaktelemente sind identisch ausgeführt. Ihr Aufbau entspricht im Wesentlichen dem des in Figur 1 dargestellten Kontaktelements. Gleiche Elemente sind mit den gleichen Bezugszeichen versehen. Analog zu der in Figur 1 dargestellten Ausführung weisen die Kontaktelemente 10 und 10' jeweils einen ersten Abschnitt 12 auf, der auf der Leiterplatte aufliegt und mit dieser verlötet ist. Die Kontaktelemente 10 und 10' weisen jeweils einen zweiten Abschnitt 16 auf, der gabelartig ausgebildet ist und jeweils eine in etwa U-förmige erste Ausnehmung 18 aufweist, die als Aufnahmemittel 17 dient. Ein U-förmig ausgebildeter Abschnitt 14 verbindet jeweils den ersten und zweiten Abschnitt 12 und 16. Im Abschnitt 14 ist eine zweite Ausnehmung 13 ausgebildet. Das Kontaktelement weist ein zapfenartiges, vertikal ausgerichtetes Positionierungselement 15 auf, dass in eine Positionierungsöffnung 25 der Leiterplatte eingreift und das Kontaktelement 10 damit auf der Leiterplatte 20 fixiert. Das Positionierungselement 15 ist einteilig mit dem Kontaktelement 10 ausgebildet. Die Ausnehmung 13 ermöglicht beim Aufsetzen des Kontaktelements auf die Leiterplatte 20 mit einem entsprechenden Werkzeug axial Druck direkt auf das Positionierungselement 15 auszuüben und das Positionierungselement 15 so in der Positionierungsöffnung 25 zu verankern. Ferner kann durch die Ausnehmung 13 die Elastizität des Kontaktelements 10 bzw. 10' erhöht werden. Damit ergibt sich eine gewisse Beweglichkeit des Abschnitts 16 und Zugspannungen in den Kontaktleitungen 30 bzw. 30' können teilweise ausgeglichen werden. Dadurch ergibt sich eine verbesserte Stabilität der elektrischen Verbindung zwischen den Kontaktelementen 10 bzw. 10' und den Kontaktleitungen 30 bzw. 30'.

Die Leiterplatte 20 weist eine Öffnung 26 auf, die als im Wesentlichen rechteckig geformter Schlitz ausgebildet ist und damit genug Platz bietet, um zwei Kontaktleitungen 30 und 30' zu den Kontaktelementen 10 und 10' zu führen. Die beiden Kontaktelemente 10 und 10' sind einander gegenüberliegend jeweils an einer kurzen Seite der Öffnung 26 angeordnet, wobei die Ausnehmungen 18 der beiden Kontaktelemente 10 und 10' einander zugewandt sind. Die erste Kontaktleitung 30 ist vom Aufnahmemittel des ersten Kontaktelements 10 aufgenommen und durch Verschweißen kontaktiert. Die zweite Kontaktleitung 30' ist vom Aufnahmemittel des zweiten Kontaktelements 10' aufgenommen und durch Verschweißen kontaktiert.

Figur 3b zeigt einen Schnitt durch die in Figur 3a dargestellte Anordnung. Zusätzlich ist noch ein Ausschnitt des Gehäuses 40 dargestellt, in dem die Leiterplatte 20 angeordnet ist. Das Gehäuse weist in diesem Beispiel zwei Durchführungsöffnungen 42 und 42' auf, durch die jeweils eine Kontaktleitung 30 bzw. 30' geführt ist. Alternativ könnte auch eine einzige Durchführungsöffnung vorgesehen sein, durch die beide Kontaktleitungen 30 und 30' geführt werden. Es ist vorteilhaft, wenn ein gewisser Abstand zwischen den Kontaktleitungen 30 und 30' bzw. zwischen den einander zugewandten Seiten der Kontaktelemente 10 und 10' eingehalten wird, um Spannungsüberschläge zu vermeiden. Die Kontaktleitungen 30 und 30' können eine isolierende Schutzumhüllung aufweisen, die lediglich im Bereich der Kontaktierung zu den Kontaktelementen 10 und 10' fehlt.

Die Durchführungsöffnungen 42 und 42' sind trichterartig mit einem sich zum Gehäuseinneren verjüngenden Querschnitt ausgebildet. Damit wird die Führung der Kontaktleitungen 30 und 30' durch die Durchführungsöffnungen 42 und 42' während der Montage der Anordnung aus Verbraucher und Gehäuse 40 vereinfacht, da die trichterförmige Ausbildung der Durchführungsöffnungen 42 und 42' eine automatischen Zentrierung und Positionierung der Kontaktleitungen 30 und 30' relativ zu der Öffnung 26 der Leiterplatte 20 und den Kontaktelementen 10 und 10' bewirkt.

In dem in den Figuren 3a und 3b dargestellten Ausführungsbeispiel einer erfindungsgemäßen Vorrichtung werden zwei identisch ausgeführte Kontaktelemente 10 und 10' eingesetzt, die im Wesentlichen der in den Figuren 1a und 1b dargestellten Ausführung entsprechen. Es ist jedoch auch denkbar, stattdessen zwei Kontaktelemente mit jeweils hülsenförmigen Aufnahmemitteln gemäß des in Figur 2 gezeigten Ausführungsbeispiels zu verwenden. Genauso sind Kombinationen von unterschiedlich geformten Kontaktelementen möglich.

## Patentansprüche

1. Vorrichtung, umfassend ein Gehäuse (40), insbesondere für ein elektronisches und/oder elektrisches Steuergerät, wobei
- das Gehäuse (40) mindestens eine Durchführungsöffnung (42, 42') aufweist,
- in dem Gehäuse (40) mindestens ein Schaltungsträger (20, 120) angeordnet ist,
- auf dem Schaltungsträger (20, 120) des Gehäuses (40) mindestens ein Kontaktelement (10, 10', 110) angeordnet und elektrisch mit dem Schaltungsträger (20, 120) kontaktiert ist,
- mindestens eine Kontaktleitung (30, 30', 130) durch die Durchführungsöffnung (42, 42') des Gehäuses (40) geführt ist und mit ihrem Ende in ein Aufnahmemittel (17, 117) des Kontaktelements (10, 10', 110) eingreift, wobei das Aufnahmemittel (17, 117) geeignet ist, die elektrische Kontaktleitung (30, 30', 130) aufzunehmen, um einen elektrischen Kontakt (19, 119) herzustellen
- über das Kontaktelement (10, 10', 110) ein elektrischer Kontakt (19, 119) von der Kontaktleitung (30, 30', 130) zu dem Schaltungsträger (20, 120) in dem Gehäuse (40) hergestellt ist,
- der Schaltungsträger (20, 120) mindestens eine Öffnung (26, 126) aufweist, die im Bereich der Durchführungsöffnung (42, 42') des Gehäuses (40) angeordnet ist, wobei das Kontaktelement (10, 10') angrenzend an die Öffnung (26) des Schaltungsträgers (20) angeordnet ist und das Aufnahmemittel (17) des Kontaktelements (10, 10') der Öffnung (26) des Schaltungsträgers (20) gegenüberliegt,
- die zumindest eine elektrische Kontaktleitung (30, 30', 130) durch die Öffnung (26, 126) des Schaltungsträgers (20, 120) geführt ist,
dadurch gekennzeichent, dass
- die zumindest eine elektrische Kontaktleitung (30, 30', 130) mit dem Kontaktelement (10, 10', 110) verschweißt ist, wobei die Schweißstelle (19) den elektrischen Kontakt zwischen der Kontaktleitung (30, 30', 130) und dem Kontaktelement (10, 10', 110) ausbildet, und
- mindestens eine Durchführungsöffnung (42, 42') des Gehäuses (40) trichterförmig ausgebildet ist und ins Innere des Gehäuses (40) konisch zuläuft.

2. Vorrichtung nach Anspruch 1, **dadurch gekennzeichnet, dass** das Kontaktelement (10, 10') einen ersten Abschnitt (12) aufweist, der zur elektrischen Kontaktierung mit dem Schaltungsträger (20) geeignet ist, und dass
- das Kontaktelement (10, 10') einen zweiten Abschnitt (16) aufweist, an dem das Aufnahmemittel (17) angeordnet ist, wobei
- der erste Abschnitt (12) und der zweite Abschnitt (16) des Kontaktelements (10, 10') parallel zueinander ausgebildet sind und durch einen Verbindungsabschnitt (14) verbunden sind.

3. Vorrichtung nach Anspruch 2, **dadurch gekennzeichnet, dass** der erste Abschnitt (12) und der zweite Abschnitt (16) auf unterschiedlichen Ebenen ausgebildet sind.

4. Vorrichtung nach einem der Ansprüche 1 bis 3, **dadurch gekennzeichnet, dass** das Aufnahmemittel (17) des Kontaktelements (10, 10') gabelförmig ausgebildet ist.

5. Vorrichtung nach Anspruch 1, **dadurch gekennzeichnet, dass** ein Abschnitt (116) des Kontaktelements (110) hülsenförmig, insbesondere hohlzylindrisch, ausgebildet ist, wobei das Aufnahmemittel (117) des Kontaktelements (110) durch den hülsenförmigen Abschnitt (116) gebildet ist.

6. Vorrichtung nach Anspruch 5, **dadurch gekennzeichnet, dass** ein zweiter Abschnitt (112) des Kontaktelements (110) kragenförmig um den ersten Abschnitt (116) des Kontaktelements (110) angeordnet ist, wobei der zweite Abschnitt (112) zur elektrischen Kontaktierung des Kontaktelements (116) mit dem Schaltungeträger (120) geeignet ist.

7. Vorrichtung nach einem der Ansprüche 5 oder 6, **dadurch gekennzeichnet, dass** das hülsenförmige Aufnahmemittel (117) in eine Öffnung (126) des Schaltungsträgers (120) einführbar ist.

8. Vorrichtung nach einem der Ansprüche 1 bis 7, **dadurch gekennzeichnet, dass** die Öffnung (26) des Schaltungsträgers (20) schlitzförmig ausgebildet ist.

9. Vorrichtung nach einem der Ansprüche 1 bis 8, **dadurch gekennzeichnet, dass** das Kontaktelement (10, 10') mindestens ein Positionierelement (15) und der Schaltungsträger (20) mindestens eine Positionierungsöffnung (25) aufweist, wobei das Positionierelement (15) des Kontaktelements (10, 10') in die entsprechende Positionieröffnung (25) des Schaltungsträgers (20) eingreift, wodurch die Position des Kontaktelements (10, 10') auf dem Schaltungsträger (20) festgelegt ist.

## Claims

1. Device comprising a housing (40), in particular for an electronic and/or electrical controller, wherein
- the housing (40) has at least one passage opening (42, 42'),
- at least one circuit carrier (20, 120) is arranged in the housing (40),
- at least one contact element (10, 10', 110) is arranged on the circuit carrier (20, 120) of the housing (40) and is electrically contact-connected to the circuit carrier (20, 120),
- at least one contact line (30, 30', 130) is routed through the passage opening (42, 42') of the housing (40) and, by way of its end, engages into a receiving means (17, 117) of the contact element (10, 10', 110), wherein the receiving means (17, 117) is suitable for receiving the electrical contact line (30, 30', 130) in order to produce an electrical contact (19, 119),
- an electrical contact (19, 119) from the contact line (30, 30', 130) to the circuit carrier (20, 120) in the housing (40) is produced by means of the contact element (10, 10', 110),
- the circuit carrier (20, 120) has at least one opening (26, 126) which is arranged in the region of the passage opening (42, 42') of the housing (40), wherein the contact element (10, 10') is arranged so as to adjoin the opening (26) of the circuit carrier (20) and the receiving means (17) of the contact element (10, 10') is situated opposite the opening (26) of the circuit carrier (20),
- the at least one electrical contact line (30, 30', 130) is routed through the opening (26, 126) of the circuit carrier (20, 120),
**characterized in that**
- the at least one electrical contact line (30, 30', 130) is welded to the contact element (10, 10', 110), wherein the weld point (19) forms the electrical contact between the contact line (30, 30', 130) and the contact element (10, 10', 110), and
- at least one passage opening (42, 42') of the housing (40) is of funnel-like design and tapers conically into the interior of the housing (40).

2. Device according to Claim 1, **characterized in that** the contact element (10, 10') has a first section (12) which is suitable for electrical contact-connection to the circuit carrier (20), and **in that**
- the contact element (10, 10') has a second section (16) on which the receiving means (17) is arranged, wherein
- the first section (12) and the second section (16) of the contact element (10, 10') are designed parallel in relation to one another and are connected by a connecting section (14).

3. Device according to Claim 2, **characterized in that** the first section (12) and the second section (16) are formed at different levels.

4. Device according to one of Claims 1 to 3, **characterized in that** the receiving means (17) of the contact element (10, 10') is of fork-like design.

5. Device according to Claim 1, **characterized in that** a section (116) of the contact element (110) is of sleeve-like, in particular hollow-cylindrical, design, wherein the receiving means (117) of the contact element (110) is formed by the sleeve-like section (116).

6. Device according to Claim 5, **characterized in that** a second section (112) of the contact element (110) is arranged in the manner of a collar around the first section (116) of the contact element (110), wherein the second section (112) is suitable for electrically contact-connecting the contact element (116) to the circuit carrier (120).

7. Device according to either of Claims 5 and 6, **characterized in that** the sleeve-like receiving means (117) can be inserted into an opening (126) of the circuit carrier (120).

8. Device according to one of Claims 1 to 7, **characterized in that** the opening (26) of the circuit carrier (20) is of slot-like design.

9. Device according to one of Claims 1 to 8, **characterized in that** the contact element (10, 10') has at least one positioning element (15) and the circuit carrier (20) has at least one positioning opening (25), wherein the positioning element (15) of the contact element (10, 10') engages into the corresponding positioning opening (25) of the circuit carrier (20), as a result of which the position of the contact element (10, 10') on the circuit carrier (20) is fixed.

## Revendications

1. Dispositif, comprenant un boîtier (40), notamment pour un contrôleur électronique et/ou électrique,
- le boîtier (40) possédant au moins une ouverture de passage (42, 42'),
- au moins un porte-circuit (20, 120) étant disposé dans le boîtier (40),
- au moins un élément de contact (10, 10', 110) étant disposé sur le porte-circuit (20, 120) du boîtier (40) et étant mis en contact électrique avec le porte-circuit (20, 120),
- au moins une ligne de contact (30, 30', 130) passant à travers l'ouverture de passage (42, 42') du boîtier (40) et venant en prise avec son extrémité dans un moyen d'accueil (17, 117) de l'élément de contact (10, 10', 110), le moyen d'accueil (17, 117) étant adapté pour accueillir la ligne de contact électrique (30, 30', 130) afin d'établir un contact électrique (19, 119),
- un contact électrique (19, 119) étant établi de la ligne de contact (30, 30', 130) au porte-circuit (20, 120) dans le boîtier (40) par le biais de l'élément de contact (10, 10', 110),
- le porte-circuit (20, 120) possédant au moins une ouverture (26, 126) qui est disposée dans la zone de l'ouverture de passage (42, 42') du boîtier (40), l'élément de contact (10, 10') étant disposé contigu à l'ouverture (26) du porte-circuit (20) et le moyen d'accueil (17) de l'élément de contact (10, 10') se trouvant à l'opposé de l'ouverture (26) du porte-circuit (20),
- l'au moins une ligne de contact électrique (30, 30', 130) passant à travers l'ouverture (26, 126) du porte-circuit (20, 120),
**caractérisé en ce que**
- l'au moins une ligne de contact électrique (30, 30', 130) est soudée avec l'élément de contact (10, 10', 110), le point de soudage (19) formant le contact électrique entre la ligne de contact (30, 30', 130) et l'élément de contact (10, 10', 110), et
- au moins une ouverture de passage (42, 42') du boîtier (40) est réalisée en forme d'entonnoir et s'étend de manière conique à l'intérieur du boîtier (40).

2. Dispositif selon la revendication 1, **caractérisé en ce que** l'élément de contact (10, 10') possède une première portion (12) qui est adaptée à la mise en contact électrique avec le porte-circuit (20), et **en ce que**
- l'élément de contact (10, 10') possède une deuxième portion (16) au niveau de laquelle est disposé le moyen d'accueil (17),
- la première portion (12) et la deuxième portion (16) de l'élément de contact (10, 10') étant configurées parallèles l'une à l'autre et étant reliées par une portion de liaison (14).

3. Dispositif selon la revendication 2, **caractérisé en ce que** la première portion (12) et la deuxième portion (16) sont réalisées sur des plans différents.

4. Dispositif selon l'une des revendications 1 à 3, **caractérisé en ce que** le moyen d'accueil (17) de l'élément de contact (10, 10') est réalisé en forme de fourche.

5. Dispositif selon la revendication 1, **caractérisé en ce qu'**une portion (116) de l'élément de contact (110) est réalisée en forme de douille, notamment cylindrique creux, le moyen d'accueil (117) de l'élément de contact (110) étant formé par la portion (116) en forme de douille.

6. Dispositif selon la revendication 5, **caractérisé en ce qu'**une deuxième portion (112) de l'élément de contact (110) est disposée en forme de collerette autour de la première portion (116) de l'élément de contact (110), la deuxième portion (112) étant adaptée à la mise en contact électrique de l'élément de contact (116) avec le porte-circuit (120).

7. Dispositif selon l'une des revendications 5 ou 6, **caractérisé en ce que** le moyen d'accueil (117) en forme de douille peut être introduit dans une ouverture (126) du porte-circuit (120).

8. Dispositif selon l'une des revendications 1 à 7, **caractérisé en ce que** l'ouverture (26) du porte-circuit (20) est réalisée en forme de fente.

9. Dispositif selon l'une des revendications 1 à 8, **caractérisé en ce que** l'élément de contact (10, 10') possède au moins un élément de positionnement (15) et le porte-circuit (20) au moins une ouverture de positionnement (25), l'élément de positionnement (15) de l'élément de contact (10, 10') venant en prise dans l'ouverture de positionnement (25) du porte-circuit (20), ce par quoi la position de l'élément de contact (10, 10') sur le porte-circuit (20) est définie.
